(19) Europäisches Patentamt
European Patent Office
Office européen des brevets

(11) EP 4 606 862 A1

(12) **EUROPEAN PATENT APPLICATION**
published in accordance with Art. 153(4) EPC

(43) Date of publication:
**27.08.2025 Bulletin 2025/35**

(21) Application number: **23879545.4**

(22) Date of filing: **22.09.2023**

(51) International Patent Classification (IPC):
***C08L 83/07*** *(2006.01)* ***C08K 3/013*** *(2018.01)*
***C08K 3/105*** *(2018.01)* ***C08L 83/05*** *(2006.01)*
***C09K 5/14*** *(2006.01)* ***H01L 23/36*** *(2006.01)*
***H01L 23/373*** *(2006.01)*

(52) Cooperative Patent Classification (CPC):
**C08K 3/013; C08K 3/105; C08L 83/04; C09K 5/14; H01L 23/36; H01L 23/373**

(86) International application number:
**PCT/JP2023/034513**

(87) International publication number:
**WO 2024/084897 (25.04.2024 Gazette 2024/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.10.2022 JP 2022167551**

(71) Applicant: **SHIN-ETSU CHEMICAL CO., LTD.**
**Tokyo 1000005 (JP)**

(72) Inventors:
- **YAMADA Kunihiro**
  **Annaka-shi, Gunma 379-0224 (JP)**
- **KUBONO Toko**
  **Annaka-shi, Gunma 379-0224 (JP)**
- **TSUJI Kenichi**
  **Annaka-shi, Gunma 379-0224 (JP)**

(74) Representative: **Angerhausen, Christoph**
**Boehmert & Boehmert**
**Anwaltspartnerschaft mbB**
**Pettenkoferstrasse 22**
**80336 München (DE)**

# (54) CURABLE ORGANOPOLYSILOXANE COMPOSITION AND SEMICONDUCTOR DEVICE

(57) Provided is a curable organopolysiloxane composition containing a required and sufficient amount of a material that has a favorable thermal conductivity and is uniformly dispersed in the state of fine particles in a matrix comprised of a resin component, where the composition can then be turned into a cured product exhibiting no cracks or voids when the product is cured. The curable organopolysiloxane composition contains (A) an organopolysiloxane having at least two silicon atom-bonded alkenyl groups per each molecule, said organopolysiloxane being liquid at 25°C, (B) an organohydrogenpolysiloxane having a silicon atom-bonded hydrogen atom, (C) at least one selected from the group consisting of gallium and a gallium alloy that have a melting point of -20 to 70°C, (D) a thermally conductive filler having an average particle diameter of 0.1 to 30 μm, and (E) a platinum group metal catalyst, wherein the gallium and/or the gallium alloy (C) is in the form of particles dispersed in the organopolysiloxane and exhibits a solidifying point of -40°C or lower.

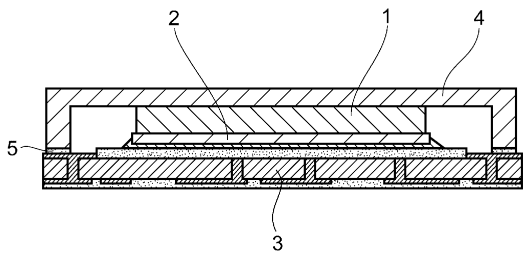


FIG.1

EP 4 606 862 A1

## Description

### Technical Field

The present invention relates to a curable organopolysiloxane composition, a method of producing such composition, a cured product of such composition, a use of such cured product as a thermally conductive layer, a semiconductor device having such thermally conductive layer, and a method of producing such semiconductor device.

### Background Art

A heat-generating electronic component mounted on a printed wiring board, such as an IC package, e.g., a CPU, may experience deterioration in performance or damage due to a temperature rise caused by heat generated during use. For this reason, heat dissipation has been achieved by arranging or applying a thermally conductive sheet with a favorable thermal conductivity or a thermally conductive grease between an IC package and a heat dissipation fin-equipped heat dissipation member whereby the heat generated from the IC package or the like can be efficiently transferred to the heat dissipation member and dissipated therefrom. However, as electronic components and the like are becoming more sophisticated, the amount of heat they generate tends to increase even more, resulting in a demand to develop a material or member that is even more excellent in thermal conductivity than those of the conventional ones.

A conventional thermally conductive sheet has an advantage in terms of work and process in that it can be easily mounted and installed. Further, a thermally conductive grease has an advantage in that irrespective of the unevenness of the surfaces of, for example, a CPU and a heat dissipation member, it can conform with such unevenness and allows the two to be adhered to each other without forming a gap(s) therebetween, whereby there can be achieved a small interfacial thermal resistance. However, a thermally conductive sheet and a thermally conductive grease have a disadvantage in that while they are both produced by adding a thermally conductive filler for the purpose of imparting a thermal conductivity, the upper limit of the amount of such thermally conductive filler added is limited and a sufficient thermal conduction effect cannot be achieved accordingly. This is because in the case of a thermally conductive sheet, one has to make sure that workability and processibility during a production process thereof will not be impaired; and in the case of a thermally conductive grease, it is required that the upper limit of an apparent viscosity of the grease be limited to a certain level so that there will be no problem in workability when using a syringe or the like to apply the same to a heat-generating electronic component or the like.

In this regard, there have been proposed a method of adding a low-melting-point metal into a thermally conductive paste (Patent document 1: JP-A-Hei 7-207160, Patent document 2: JP-A-H08-53664), and a granular material capable of immobilizing and thus stabilizing a liquid metal in a three-phase composite (Patent document 3: JP-A-2002-121292). However, the problems with these thermally conductive materials employing low-melting-point metals are, for example, such that a part(s) other than the part to be coated will be contaminated, and that an oily substance will leak out if used for a long period of time. In order to solve these problems, there has been proposed a method of dispersing gallium and/or a gallium alloy into a curable silicone (Patent document 4: Japanese Patent No. 4551074); when the composition has a large thickness, there will be observed a low thermal conductivity, thus leading to an insufficiently satisfactory result(s). Further, there has been proposed a method for raising the thermal conductivity thereof (Patent document 5: Japanese Patent No. 4913874, Patent document 6: Japanese Patent No. 5640945); a satisfactory performance(s) cannot be delivered as cracks and voids occur easily at the time of curing. Further, heat-generating electric components sometimes lose their reliability when exposed to an extremely low temperature environment as low as, for example, -40°C.

### Prior Art Documents

#### Patent documents

Patent document 1: JP-A-H07-207160
Patent document 2: JP-A-H08-53664
Patent document 3: JP-A-2002-121292
Patent document 4: JP-B-4551074
Patent document 5: JP-B-4913874
Patent document 6: JP-B-5640945

### Summary of Invention

Technical Problem

Thus, it is an object of the present invention to obtain a curable organopolysiloxane composition containing a required and sufficient amount of a material that has a favorable thermal conductivity and is uniformly dispersed in the state of fine particles in a matrix comprised of a resin component, where the composition can then be turned into a cured product exhibiting no cracks or voids when the product is cured. It is also an object of the present invention to provide a method of producing the curable organopolysiloxane composition.

Moreover, another object of the present invention is to provide a use of the curable organopolysiloxane composition as a thermally conductive layer composed of a cured product thereof that is crosslinked by thermal treatment, wherein the composition is arranged to be sandwiched between a heat-generating electrical component and a heat dissipation member in a manner similar to a conventional thermally conducting grease such that the composition conforms to the irregularities of the surface of the component or member without forming any clearance. In addition, it is yet another object of the present invention to provide a semiconductor device with an excellent heat dissipation performance, in which a heat-generating electronic component and a heat dissipation member are bonded together via the thermally conductive layer; and a method for producing such semiconductor device.

**Solution to Problem**

In order to solve the above problems, the inventors of the present invention diligently conducted a series of studies, and they discovered that the formulation of gallium and/or an alloy thereof having a low melting point, a specific type of alkoxypolysiloxane, a specific type of organohydrogenpolysiloxane bonded to a silicon atom, and a thermally conductive filler easily results in a composition in which the gallium and/or the alloy thereof is uniformly dispersed therein in the state of fine particles whose solidifying point decreases to a temperature of -40°C or lower, thus exhibiting highly reliable performance even under an extremely low-temperature environment of lower than or equal to -40°C. The inventors also obtained knowledge that the composition is less likely to cause cracks or voids during the process of thermally treating the composition to form a cured product. The inventors further obtained knowledge that the cured product of the composition having a specific range of storage elastic modulus results in a product having high reliability.

Next, the inventors obtained knowledge that the cured product obtained as above may be placed to be sandwiched in between a heat-generating electronic component and a heat dissipation member in a layer-wise manner to use it as a thermally conductive layer with low thermal resistance so that the heat generated during operation of the heat-generating electronic component can be quickly transferred via such thermally conductive layer containing the gallium and/or alloy thereof that are immobilized and retained in the above structure to the heat dissipation member, and that this knowledge may be used to produce a semiconductor product superior in heat dissipation property, and thus the present invention has been completed based on these findings.

Specifically, the present invention provides a curable organopolysiloxane composition and a semiconductor device using such curable organopolysiloxane composition, which are as defined below.

<1> A curable organopolysiloxane composition comprising the components (A) to (E) of: (A) an organopolysiloxane having at least two silicon atom-bonded alkenyl groups per each molecule, said organopolysiloxane being liquid at 25°C; (B) an organohydrogenpolysiloxane having a silicon atom-bonded hydrogen atom; (C) at least one selected from the group consisting of gallium and a gallium alloy that have a melting point of -20 to 70°C; (D) a thermally conductive filler having an average particle diameter of 0.1 to 30 μm; and (E) a platinum group metal catalyst, wherein the gallium and/or the gallium alloy (C) is in the form of particles dispersed in the organopolysiloxane and exhibits a solidifying point of -40°C or lower.
The solidifying temperature is determined using a Differential Scanning Calorimeter (DSC) as a temperature of the maximum peak position of the exothermic curve obtained after the curable organopolysiloxane composition is cooled at 3°C/minute from 25°C to -80°C.

<2> The curable organopolysiloxane composition according to <1>, comprising the components (A) to (G1) of:

(A) 100 parts by mass of organopolysiloxane consisting of:

(A-1) an organopolysiloxane having at least two silicon atom-bonded alkenyl groups per each molecule and having a viscosity of 0.01 to 10 Pa·s at 25°C; and
(A-2) an organopolysiloxane having at least two silicon atom-bonded alkenyl groups per each molecule and having a viscosity of 11 to 1,000 Pa·s at 25°C,

wherein a ratio by mass of the (A-1) relative to the total amount by mass of the (A-1) and (A-2) is 10 to 90% by mass;
(B) an organohydrogenpolysiloxane having at least two silicon atom-bonded hydrogen atoms per each molecule, the component (B) being in an amount where the number of the silicon atom-bonded hydrogen atoms in the component is 0.1 to 5.0 per one alkenyl group in the component (A);
(C) 300 to 20,000 parts by mass of at least one selected from the group consisting of gallium and a gallium alloy that have a melting point of -20 to 70°C;
(D) 10 to 1,000 parts by mass of a thermally conductive filler having an average particle diameter of 0.1 to 30 μm;
(E) 0.1 to 500 ppm of a platinum group metal catalyst in terms of platinum group metal mass with respect to the mass of the component (A); and
(G-1) 10 to 500 parts by mass of an organopolysiloxane represented by a general formula (1) define as:

[Chemical formula 1]

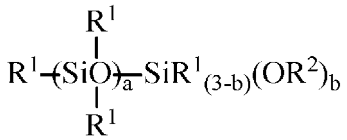

(1)

wherein, in the formula (1), $R^1$s represent identical or different alkyl groups, $R^2$ represents an alkyl group, an alkenyl group, or an acyl group, a is an integer of 5 to 100, b is an integer of 1 to 3.

<3> The curable organopolysiloxane composition according to <2>, further comprising
(G-2) 0.1 to 100 parts by mass of an alkoxysilane compound per 100 parts by mass of the component (A), said alkoxysilane compound being represented by a general formula (2) defined as

$$R^3_cR^4_dSi(OR^5)_{4-c-d} \quad (2)$$

wherein, in the formula (2), $R^3$ independently represents an alkyl group having 6 to 16 carbon atoms, $R^4$ independently represents a substituted or unsubstituted monovalent hydrocarbon group having 1 to 8 carbon atoms, $R^5$ independently represents an alkyl group having 1 to 6 carbon atoms, c is an integer of 1 to 3, d is an integer of 0 to 2, and a sum of c + d is an integer of 1 to 3.

<4> The curable organopolysiloxane composition according to <2> or <3>, further comprising (G-3) 0.1 to 100 parts by mass of trifluoropropyltrimethoxysilane per 100 parts by mass of the component (A).

<5> The curable organopolysiloxane composition according to any one of <1> to <4>, wherein the component (B) is an organohydrogenpolysiloxane that has 5 or more silicon atom-bonded hydrogen atoms at non-terminal moieties of the molecular chain per molecule, and satisfies a formula (3) defined as:

$$0.1 < \alpha/\beta \quad (3),$$

wherein, in the formula (3), α represents the number of the hydrogen atoms bonded to the silicon atoms at the non-terminal moieties of the molecular chain, and β represents the number of all the silicon atoms in the component (B).

<6> The curable organopolysiloxane composition according to any one of <1> to <5>, wherein the component (C) is dispersed in the composition in the form of particles each having a diameter of 1 to 200 μm.

<7> A thermally conductive silicone grease composition comprising the curable organopolysiloxane composition according to any one of <1> to <6>.

<8> A cured product of the curable organopolysiloxane composition according to any one of <1> to <6>.

<9> The cured product of the curable organopolysiloxane composition according to <8>, wherein the product exhibits a storage elastic modulus of 3,000 to 300,000 Pa at 25°C.

<10> A use of the cured product according to <8> as a thermally conductive layer that is sandwiched and arranged between a heat-generating electronic component and a heat dissipation member.

<11> A semiconductor device comprising:

a heat-generating electronic component;
a heat dissipation member; and
a thermally conductive layer composed of the cured product according to <8>,
wherein the heat-generating electronic component and the heat dissipation member are bonded via the thermally conductive layer.

<12> A method of producing the semiconductor device according to <11>, comprising the steps of:

(a) applying the curable organopolysiloxane composition according to any one of <1> to <6> to a surface of a heat-generating electronic component to form thereon a coating layer composed of the composition;
(b) press-bonding and fixing a heat dissipation member to the coating layer; and
(c) heating a structural body obtained after the step (b) at 80 to 180°C to cure and turn the coating layer into a thermally conductive layer.

Advantageous Effects of Invention

The curable organopolysiloxane composition of the present invention contains gallium and/or the alloy thereof that is dispersed in the organopolysiloxane as a base oil, which allows its low-melting-point metal to be present in a liquid form even when it is exposed to an extremely low-temperature environment (for example, in a space environment) as low as -40°C or lower, thus enhancing the reliability in an extremely low-temperature environment. The composition can also prevent cracks or voids from being formed when it is thermally cured. In addition, the cured product of the curable organopolysiloxane composition according to the present invention exhibits a reduced value of storage elastic modulus, which allows the product to sufficiently conform with the warpage of the board when it is thermally shocked, thus enhancing the reliability thereof.

Since the curable organopolysiloxane composition of the present invention is in the form of grease before curing, it has a favorable workability when used to coat a heat-generating electronic component such as a CPU. Further, when press-bonding a heat dissipation member, the composition will conform with the unevenness of the surfaces of the two and allow them to be adhered to each other without forming a gap(s) therebetween, thereby incurring no interfacial thermal resistance.

In addition, in the heating treatment step of curing the resin components via addition reaction, cracks and voids are less likely to occur, the gallium and/or alloy thereof contained in the composition of the present invention forms a path-like structure which is immobilized and retained in a three-dimensional crosslinked network body formed as the result of curing the resin components. For this reason, the heat generated from a heat-generating electronic component can be quickly transferred to a heat dissipation member, whereby a high heat dissipation effect can be exerted more reliably than a conventional thermally conductive sheet or thermally conductive grease. Further, since the path-forming gallium and/or alloy thereof, contained in the thermally conductive layer that is composed of the cured product of the composition of the present invention and is provided in the semiconductor device, is immobilized and retained in the three-dimensional crosslinked network body of the cured resin, other parts will not be contaminated, and an oily matter will not leak out over time, which were otherwise problems in the cases of the conventional thermally conductive greases. Thus, the reliability of a semiconductor device can be further improved.

Brief Description of Drawings

[FIG. 1] is a longitudinal cross-sectional schematic view showing one example of a semiconductor device employing the composition of the present invention.

Description of Embodiments

[Curable Organopolysiloxane Composition]

<(A) Organopolysiloxane>

The composition of the present invention contains an organopolysiloxane as a component (A) having at least two

silicon atom-bonded alkenyl groups per each molecule, wherein the composition is liquid at 25°C, and the component (A) is the main agent (base polymer) in an addition reaction curing system of the present invention. The component (A) is preferably composed of the following (A-1) and (A-2).

(A-1) Organopolysiloxane that has at least two silicon atom-bonded alkenyl groups per molecule, and has a viscosity of 0.01 to 10 Pa·s at 25°C

(A-2) Organopolysiloxane that has at least two silicon atom-bonded alkenyl groups per molecule, and has a viscosity of 11 to 1,000 Pa·s at 25°C

The viscosity of (A-1) is preferably in a range of 0.1 to 5 Pa·s, more preferably of 0.1 to 1 Pa·s. When the viscosity of (A-1) is lower than 0.01 Pa·s, a cured product will become brittle so that cracks are more likely to occur; when the viscosity of (A-1) is higher than 10 Pa·s, the cured product will become soft so that voids are more likely to occur.

The viscosity of (A-2) is preferably in a range of 15 to 500 Pa·s, more preferably of 20 to 100 Pa·s. When the viscosity of (A-2) is lower than 11 Pa·s, it will be difficult for the composition to be turned into a grease-like product as the ingredients will not be stirred and sheared at the time of production; when the viscosity of (A-2) is larger than 1,000 Pa·s, it will be difficult to handle the composition due to its excessively increased degree of viscosity.

Here, in the present invention, the viscosity is a value measured at 25°C by a spiral viscometer PC-1TL (by Malcom Co., Ltd.).

A ratio of (A-1) to the sum of (A-1) and (A-2) is 10 to 90% by mass, preferably 20 to 80% by mass, more preferably 30 to 70% by mass.

When the ratio of (A-1) is smaller than 10% by mass, the cured product will become soft so that voids are more likely to occur at the time of curing; when the ratio of (A-1) is larger than 90% by mass, it will be difficult for the composition to be turned into a grease-like product as the ingredients will not be stirred and sheared at the time of production.

The molecular structures of the organopolysiloxanes (A-1) and (A-2) are not limited; there may be listed, for example, a linear, a branched, and a partially branched linear structure, of which a linear structure is particularly preferred.

In each of (A-1) and (A-2), the number of the silicon atom-bonded alkenyl groups per molecule may be 2 or more, preferably 2 to 10, more preferably 2 to 5.

The silicon atom-bonded alkenyl group may, for example, be a vinyl group, allyl group, 1-butenyl group, or 1-hexenyl group. Among these groups, a vinyl group is preferred due to its high versatility. This alkenyl group may be bonded to either the silicon atom at the molecular chain terminal or the silicon atom in the midway of the molecular chain; in order to improve the flexibility of the resulting cured product, it is preferred that such alkenyl group be present as a group bonded only to the silicon atom at the molecular chain terminal.

A silicon atom-bonded group other than an alkenyl group may, for example, be a substituted or unsubstituted monovalent hydrocarbon group. Examples of such monovalent hydrocarbon group include an alkyl group such as a methyl group, an ethyl group, a propyl group, a butyl group, a pentyl group, a hexyl group, a heptyl group, an octyl group, a nonyl group, a decyl group, and a dodecyl group; a cycloalkyl group such as a cyclopentyl group and a cyclohexyl group; an aryl group such as a phenyl group, a tolyl group, a xylyl group, and a naphthyl group; an aralkyl group such as a benzyl group, 2-phenylethyl group, and 2-phenylpropyl group; and a halogenated alkyl group such as a chloromethyl group, 3,3,3-trifluoropropyl group, and 3-chloropropyl group. In terms of synthesis and economic efficiency, it is preferred that 90% or more of them are methyl groups.

Specific and preferable examples of such organopolysiloxane include a polydimethylsiloxane with both molecular chain terminals being blocked by dimethylvinylsiloxy groups, a polydimethylsiloxane with both molecular chain terminals being blocked by methyldivinylsiloxy groups, and a dimethylsiloxane-methylphenylsiloxane copolymer with both molecular chain terminals being blocked by dimethylvinylsiloxy groups.

<(B) Organohydrogenpolysiloxane>

A component (B) of the composition of the present invention is an organohydrogenpolysiloxane that has at least two silicon atom-bonded hydrogen atoms (hereinafter referred to as "Si-H groups") per molecule, and acts as a cross-linking agent for the component (A). That is, due to the function of a later-described platinum-based catalyst as a component (E) to be explained below, these Si-H groups in the component (B) are to be added to the alkenyl groups in the component (A) via a hydrosilylation reaction, whereby there can be obtained a crosslinked cured product having a three-dimensional network structure that contains cross-linking bonds.

The number of Si-H groups in the component (B) is two or more per molecule, preferably 5 or more per molecule in terms of suppressing voids at the time of curing, even more preferably 10 or more per molecule. Further, it is more preferred that the component (B) be an organohydrogenpolysiloxane that has 5 or more silicon atom-bonded hydrogen atoms at non-terminal moieties of the molecular chain per molecule, and satisfies a formula (3) defined as:

$$0.1 < \alpha/\beta \qquad (3)$$

wherein, in the formula (3), α represents the number of the hydrogen atoms bonded to the silicon atoms at the non-terminal moieties of the molecular chain, and β represents the number of all the silicon atoms in the component (B).

When α/β is as small as 0.1 or smaller, voids are likely to occur at the time of curing; thus, it is also required that it satisfies 0.1 < α/β. In this case, α/β is preferably not smaller than 0.11, particularly preferably not smaller than 0.12. The upper limit of α/β is not particularly limited; α/β is preferably not larger than 0.95, particularly preferably not larger than 0.90.

The component (B) may have any molecular structure which is not particularly limited so long as it meets the above conditions; the molecular structure thereof may be any of conventionally known structures such as a linear structure, a cyclic structure, a branched structure, and a three-dimensional network (resin) structure. The number of silicon atoms per molecule (or polymerization degree) is normally 3 to 1,000, preferably 5 to 400, more preferably 10 to 300, even more preferably 10 to 100, and particularly preferably 10 to 60.

The kinetic viscosity of the organohydrogenpolysiloxane as the component (B) is normally 1 to 10,000 $mm^2/s$, preferably 3 to 5,000 $mm^2/s$, more preferably 5 to 3,000 $mm^2/s$; it is preferred that the organohydrogenpolysiloxane as the component (B) be liquid at room temperature (25°C). Here, this kinetic viscosity is a value measured by an Ostwald viscometer at 25°C.

As an organohydrogenpolysiloxane that meets the above conditions, preferred is, for example, one represented by an average composition formula (4) defined as:

$$R^6_eH_fSiO_{(4-e-f)/2} \qquad (4)$$

wherein, in the formula (4), $R^6$ represents an aliphatic unsaturated bond-free substituted or unsubstituted monovalent hydrocarbon group, e is a number of 0.7 to 2.2, f is a number of 0.001 to 0.5, provided that e + f is a number satisfying 0.8 to 2.5.

In the formula (4), $R^6$ is normally an aliphatic unsaturated bond-free substituted or unsubstituted monovalent hydrocarbon group having 1 to 10, preferably 1 to 6 carbon atoms. Specific examples of such hydrocarbon group include an alkyl group such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; an aryl group such as a phenyl group, a tolyl group, a xylyl group, and a naphthyl group; an aralkyl group such as a benzyl group, a phenylethyl group, and a phenylpropyl group; and groups obtained by substituting part of or all the hydrogen atoms in any of these groups with halogen atoms such as fluorine atoms and chlorine atoms, as exemplified by 3,3,3-trifluoropropyl group. Preferred are an alkyl group, an aryl group, and 3,3,3-trifluoropropyl group; more preferred are a methyl group, a phenyl group, and 3,3,3-trifluoropropyl group.

In the formula (4), e, f, and e + f are each described as above. It is preferred that e be a number of 0.9 to 2.1; f be a number of 0.002 to 0.2, particularly preferably a number of 0.005 to 0.1; and e + f be a number satisfying 1.0 to 2.3, particularly preferably 1.5 to 2.2.

The organohydrogenpolysiloxane may have any molecular structure represented by the formula (4) which is not particularly limited; the molecular structure thereof may be any of, for example, a linear structure, a cyclic structure, a branched structure, and a three-dimensional network (resin) structure. Among them, a linear structure is particularly preferred as a structure with which the number of silicon atoms per molecule and the kinetic viscosity fall into the above ranges.

Specific examples of the organohydrogenpolysiloxane represented by the formula (4) include a dimethylsiloxane-methylhydrogensiloxane copolymer with both molecular chain terminals being blocked by dimethylhydrogensiloxy groups; a methylhydrogensiloxane-dimethylsiloxane-diphenylsiloxane copolymer with both molecular chain terminals being blocked by dimethylhydrogensiloxy groups; a dimethylsiloxane-methylhydrogensiloxane copolymer with one molecular chain terminal being blocked by a dimethylhydrogensiloxy group, and with the other molecular chain terminal being blocked by a trimethylsiloxy group; a methylhydrogensiloxane-dimethylsiloxane-diphenylsiloxane copolymer with one molecular chain terminal being blocked by a dimethylhydrogensiloxy group, and with the other molecular chain terminal being blocked by a trimethylsiloxy group; a copolymer composed of a $(CH_3)_2HSiO_{1/2}$ unit, $(CH_3)_3SiO_{1/2}$ unit, $(CH_3)HSiO_{2/2}$ unit, and $SiO_{4/2}$ unit; a copolymer composed of a $(CH_3)_2HSiO_{1/2}$ unit, $(CH_3)_3SiO_{1/2}$ unit, $(CH_3)HSiO_{2/2}$ unit, $(CH_3)_2SiO_{2/2}$ unit, and $SiO_{4/2}$ unit; a copolymer composed of a $(CH_3)_2HSiO_{1/2}$ unit, $(CH_3)HSiO_{2/2}$ unit, $(CH_3)_2SiO_{2/2}$ unit, and $SiO_{4/2}$ unit; a copolymer composed of a $(CH_3)_2HSiO_{1/2}$ unit, $SiO_{4/2}$ unit, $(CH_3)HSiO_{2/2}$ unit, $(CH_3)_2SiO_{2/2}$ unit, and $(C_6H_5)_3SiO_{1/2}$ unit; and a copolymer composed of a $(CH_3)_2HSiO_{1/2}$ unit, $(CH_3)_3SiO_{1/2}$ unit, $(C_6H_5)_2SiO_{2/2}$ unit, $(CH_3)HSiO_{2/2}$ unit, $(CH_3)_2SiO_{2/2}$ unit, and $SiO_{4/2}$ unit.

The component (B) is added in an amount at which the number of silicon atom-bonded hydrogen atoms in the component (B) will become 0.1 to 5.0, preferably 0.3 to 3.0, more preferably 0.5 to 2.0, per 1 silicon atom-bonded alkenyl group in the component (A). When such number of the silicon atom-bonded hydrogen atoms is smaller than 0.1, an

extremely low cross-linking density is likely to form voids at the time of curing and to flow out from the predetermined position, thus resulting in poor reliability; when such number of the silicon atom-bonded hydrogen atoms is larger than 5.0, a resulting thermally conductive silicone composition will be excessively hard, thus resulting in poor reliability.

One kind of such organohydrogenpolysiloxane as the component (B) may be used alone, or two or more kinds thereof may be used in combination.

<(C)Gallium and/or alloy thereof>

A component (C) of the composition of the present invention is gallium and/or an alloy thereof having a melting point of -20 to 70°C. The component (C) is a component added to impart a favorable thermal conductivity to the cured product obtained from the composition of the present invention, and it is the addition of this component that characterizes the present invention.

As mentioned above, the melting point of the component (C) needs to be in a range of -20 to 70°C. While those having a melting point of -20°C or lower may also be theoretically employed for use in the present invention, those having a melting point lower than -20°C are hardly available and are thus not preferable in terms of economic efficiency; meanwhile, if the melting point is greater than 70°C, the component will not quickly melt in a preparation process of the composition, which will result in a poor workability. In this way, as described above, an appropriate range of the melting point of the component (C) is a range of -20 to 70°C. Particularly, it is preferred that the melting point be in a range of -19 to 50°C, more preferably be in a range of -18 to 40°C, because the composition of the present invention can be easily prepared.

Metal gallium has a melting point of 29.8°C. Typical examples of a gallium alloy include a gallium-indium alloy, e.g., Ga-In (mass ratio = 75.4:24.6, melting point = 15.7°C); a gallium-tin alloy; a gallium-tin-zinc alloy, e.g., Ga-Sn-Zn (mass ratio = 82:12:6, melting point = 17°C); a gallium-indium-tin alloy, e.g., Ga-In-Sn (mass ratio = 68.5:21.5:10, melting point = -19°C; mass ratio = 62:25:13, melting point = 5.0°C; or mass ratio = 21.5:16.0:62.5, melting point = 10.7°C); and a gallium-indium-bismuth-tin alloy, e.g., Ga-In-Bi-Sn (mass ratio = 9.4:47.3:24.7:18.6, melting point 48.0°C).

One kind of such component (C) may be used alone, or two or more kinds thereof may be used in combination.

The liquid or solid fine particles of gallium and/or the alloy thereof present in the composition of the present invention when the composition is in an uncured state, each has a substantially spherical shape, and amorphous particles may also be contained therein. Further, the average particle diameter thereof is normally 1 to 200 μm, particularly preferably 5 to 150 μm, more preferably 10 to 100 μm. An unduly small average particle diameter will lead to an excessively high viscosity of the composition, which will result in poor extensibility and a problematic coating workability accordingly; meanwhile, an excessively large average particle diameter will lead to an ununiform composition, which will make it difficult to turn the composition into the shape of a thin film on a heat-generating electronic component or the like via coating. Here, as described above, since the composition is to be immediately stored under a low temperature after its preparation, the aforesaid shape, average particle diameter, and dispersed state in the composition can be maintained until a coating step of applying the composition to a heat-generating electronic component or the like. Specifically, the average particle diameter was calculated by conducting observation using VR-3000 manufactured by KEYENCE CORPORATION, with the uncured composition product being sandwiched by two pieces of glass slide. That is, 30 particles were randomly selected from an image taken by this measurement device, the particle diameter of each particle was then measured, and an average value thereof was then calculated.

The inventors discovered that this component (C) exhibits a solidifying point that is lower than the solidifying point of the bulk when the component (C) is dispersed in the component (A) to have a particle diameter within the range as defined above.

Electric components are often exposed to an extremely low-temperature environment, and thus it is preferred in terms of reliability that the component (C) in the composition of the present invention have a solidifying point of -40°C or lower, more preferably -50°C or lower, and even more preferably -60°C or lower. The solidifying temperature was determined as a temperature of the maximum peak position of the exothermic curve obtained after the curable organopolysiloxane composition was cooled at 3°C/minute from 25°C to -80°C. This measurement may be carried out using a Differential Scanning Calorimeter (DSC) of the model DSC7000X manufactured by Hitachi High-Tech Science Corporation.

The component (C) is added in an amount of 300 to 20,000 parts by mass, particularly preferably 2,000 to 15,000 parts by mass, more preferably 3,000 to 12,000 parts by mass, per 100 parts by mass of the component (A). A low thermal conductivity will result if the component (C) is added in an amount of smaller than 300 parts by mass; in such case, if the composition is thick, there may not be achieved a satisfactory heat dissipation performance. If the amount of the component (C) added is larger than 20,000 parts by mass, it will be difficult to obtain a uniform composition, and since the viscosity of the composition will be excessively high in such case, the composition may not be able to be obtained as a grease-like composition having extensibility.

<(D) Thermally conductive filler>

Together with the component (C), a thermally conductive filler (D) (except the component (C)) that is to be added to a conventionally known thermally conductive sheet or thermally conductive grease needs to be added to the composition of the present invention.

This component (D) is not particularly limited so long as it has a favorable thermal conductivity; those that are conventionally known can all be used, and examples of which may include an aluminum powder, a zinc oxide powder, an alumina powder, a boron nitride powder, an aluminum nitride powder, a silicon nitride powder, a copper powder, a diamond powder, a nickel powder, a zinc powder, a stainless steel powder, and a carbon powder. Here, one kind of such component (D) may be used alone, or two or more kinds thereof may be used in combination.

Specifically, a zinc oxide powder and an alumina powder are particularly preferred in terms of availability and economic efficiency.

The average particle diameter of the component (D) is 0.1 to 30 μm, preferably 1 to 20 μm. An unduly small average particle diameter will lead to an excessively high viscosity of the composition obtained, which will result in poor extensibility. Meanwhile, an excessively large average particle diameter will make it difficult to obtain a uniform composition. Here, this average particle diameter is a volume average diameter [MV] on a volumetric basis that is measured by Microtrac MT3300EX (by Nikkiso Co., Ltd.).

When the component (D) is added in an amount of smaller than 10 parts by mass per 100 parts by mass of the component (A), gallium and/or the alloy thereof will not be uniformly dispersed in the component (A) or a mixture of the component (A) and a later-described component (G); when the component (D) is added in an amount of larger than 1,000 parts by mass per 100 parts by mass of the component (A), there will be a problem that due to excessively high viscosity of the composition, the composition cannot be obtained as a grease-like composition having extensibility. Thus, the component (D) is added in an amount of 10 to 1,000 parts by mass, preferably of 50 to 500 parts by mass.

<(E) Platinum group metal catalyst>

A platinum group metal catalyst as a component (E) of the composition of the present invention is a component (curing catalyst) added to promote the addition reaction between the alkenyl groups in the component (A) and the SiH groups in the component (B), and thereby yield a three-dimensionally networked crosslinked cured product from the composition of the present invention.

As such component (E), any one or more of known ingredients that are used for normal hydrosilylation reactions may be used, examples of which may include platinum metal (platinum black), chloroplatinic acid, a platinum-olefin complex, a platinum-alcohol complex, and a platinum coordination compound. The amount of the component (E) added is not particularly limited so long as it is an effective amount required to cure the composition of the present invention; for example, it is preferred that the component (E) be normally added in an amount of about 0.1 to 500 ppm in terms of platinum atoms with respect to the mass of the component (A).

<(G-1) Surface treatment agent>

It is preferred that a polysiloxane represented by the following general formula (1) be added to the composition of the present invention as a surface treatment agent (G-1); this surface treatment agent (G-1) is added for the purposes of hydrophobizing the gallium and/or alloy thereof as the component (C) at the time of preparing the composition, and improving a wettability of the component (C) to the organopolysiloxane as the component (A) so as to allow the component (C) as fine particles to be uniformly dispersed in a matrix composed of the component (A).

Further, this component (G-1) also has the function of improving the wettability of the surface of the thermally conductive filler as the component (D), and thereby imparting a favorable uniform dispersibility to the filler.

The component (G-1) is a polysiloxane represented by the following general formula (1):

[Chem. 2]

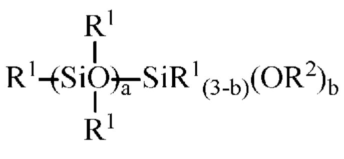

(1)

wherein, in the formula (1), $R^1$s represent identical or different alkyl groups, $R^2$ represents an alkyl group, an alkenyl group, or an acyl group, a is an integer of 5 to 100, b is an integer of 1 to 3, and wherein one molecular chain terminal of this

polysiloxane is blocked by a hydrolyzable group, and the polysiloxane has a kinetic viscosity of 10 to 10,000 $mm^2/s$ at 25°C. Here, this kinetic viscosity is a value measured by an Ostwald viscometer at 25°C.

It is preferable if the component (G-1) is added in an amount not smaller than 10 parts by mass per 100 parts by mass of the component (A), because the components (C) and (D) will be satisfactorily dispersed therein to obtain a uniform grease composition; however, if the component (G-1) is added in an amount of larger than 500 parts by mass per 100 parts by mass of the component (A), there will be a problem that since the component (A) will thus be relatively contained in a smaller amount, the composition obtained will not be cured easily. Without curing, the grease may be misaligned after being applied to a device such as CPU, whereby a significantly deteriorated performance may be observed. Thus, the component (G-1) is added in an amount within 10 to 500 parts by mass, preferably 50 to 300 parts by mass.

<Other components>

In addition to the above essential components, the curable organopolysiloxane composition of the present invention may further contain the following components as appropriate.

<(F) Addition reaction controller>

An addition reaction controller as a component (F) of the composition of the present invention is a component that is added as appropriate, and is a component added to inhibit the hydrosilylation reaction caused by the action of the platinum-based catalyst at room temperature so as to secure a work life (i.e. shelf life, pot life) of the composition of the present invention and thereby pose no obstacles to the operation of applying the composition to a heat-generating electronic component or the like.

As such component (F), any one or more of known addition reaction controllers that are used in normal addition reaction-curable silicone compositions may be used, examples of which may include acetylene compounds such as 1-ethynyl-1-cyclohexanol and 3-butyn-1-ol; and various types of nitrogen compounds, organic phosphorus compounds, oxime compounds, and organic chloro compounds.

The amount of the component (F) added varies depending on the amount of the component (E) used, and cannot be categorically determined; the amount of the component (F) is not particularly limited so long as it is an effective amount capable of inhibiting the progression of the hydrosilylation reaction. For example, the component (F) may be normally added in an amount of about 0.001 to 5 parts by mass per 100 parts by mass of the component (A). If the amount of the component (F) added is unduly small, there cannot be secured a sufficient work life; if the amount of the component (F) added is excessively large, the curability of the composition of the present invention will be impaired. Here, in order to improve its dispersibility in the composition, this component (F), if necessary, may also be diluted with an organic solvent such as toluene, xylene, and isopropyl alcohol before use.

Moreover, the composition of the present invention may further contain the following alkoxysilane as a component (G-2).

(G-2) is represented by the following general formula (2):

$$R^3{}_cR^4{}_dSi(OR^5)_{4-c-d} \qquad (2)$$

wherein, in the formula (2), $R^3$ independently represents an alkyl group having 6 to 16 carbon atoms, $R^4$ independently represents a substituted or unsubstituted monovalent hydrocarbon group having 1 to 8 carbon atoms, $R^5$ independently represents an alkyl group having 1 to 6 carbon atoms, c is an integer of 1 to 3, d is an integer of 0 to 2, and a sum of c + d is an integer of 1 to 3.

Examples of $R^3$ in the general formula (2) include a hexyl group, an octyl group, a nonyl group, a decyl group, a dodecyl group, and a tetradecyl group. When the number of carbon atoms is smaller than 6, improvement in wettability of the components (C) and (D) will be insufficient; when the number of carbon atoms is greater than 16, the organosilane as the component (G-2) will solidify at room temperature, which will lead to an inconvenient handling and an impaired low-temperature property of the resultant composition.

Further, examples of $R^4$ in the general formula (2) include an alkyl group such as a methyl group, an ethyl group, a propyl group, a hexyl group, and an octyl group; a cycloalkyl group such as a cyclopentyl group and a cyclohexyl group; an alkenyl group such as a vinyl group and an allyl group; an aryl group such as a phenyl group and a tolyl group; an aralkyl group such as 2-phenylethyl group and 2-methyl-2-phenylethyl group; and a halogenated hydrocarbon group such as 3,3,3-trifluoropropyl group, 2-(nonafluorobutyl)ethyl group, 2-(heptadecafluorooctyl)ethyl group, and p-chlorophenyl group. Among them, a methyl group and an ethyl group are particularly preferred.

Moreover, examples of $R^5$ in the general formula (2) include an alkyl group such as a methyl group, an ethyl group, a propyl group, a butyl group, a pentyl group, and a hexyl group. Among them, a methyl group and an ethyl group are particularly preferred.

Preferable and specific examples of the component (G-2) are as follows.

$C_6H_{13}Si(OCH_3)_3$

$C_{10}H_{21}Si(OCH_3)_3$

$C_{12}H_{25}Si(OCH_3)_3$

$C_{12}H_{25}Si(OC_2H_5)_3$

$C_{10}H_{21}(CH_3)Si(OCH_3)_2$

$C_{10}H_{21}(C_6H_5)Si(OCH_3)_2$

$C_{10}H_{21}(CH_3)Si(OC_2H_5)_2$

$C_{10}H_{21}(CH{=}CH_2)Si(OCH_3)_2$

Here, one kind of such component (G-2) may be used alone, or two or more kinds thereof may be used in combination. Further, when the component (G-2) is added in an amount of not smaller than 0.1 parts by mass per 100 parts by mass of the component (A), the viscosity of the composition is likely to fall into a desired range; when the component (G-2) is added in an amount of larger than 100 parts by mass per 100 parts by mass of the component (A), the wetter effect will not intensify, and an economic inefficiency will thus be incurred. In this way, a range of 0.1 to 100 parts by mass is preferable. A range of 1 to 50 parts by mass is more preferable.

Moreover, the composition of the present invention may further contain trifluoropropyltrimethoxysilane as a component (G-3) in some cases. Further, when the component (G-3) is added in an amount not smaller than 0.1 parts by mass per 100 parts by mass of the component (A), the viscosity of the composition is likely to fall into a desired range; when the component (G-3) is added in an amount of larger than 100 parts by mass per 100 parts by mass of the component (A), the wetter effect will not intensify, and an economic inefficiency will thus be incurred. In this way, a range of 0.1 to 100 parts by mass is preferable. A range of 1 to 50 parts by mass is more preferable.

Here, the components (G-1), (G-2) and (G-3) may each be used alone, or they may be used in a combined manner.

<Optional components other than those listed above>

The composition of the present invention may also contain an organopolysiloxane represented by the following average composition formula (5) to the extent that the purposes and effects of the present invention are not impaired.

It is an organopolysiloxane that is represented by an average composition formula (5) defined as:

$$R^7_gSiO_{(4-g)/2} \qquad (5)$$

wherein, in the formula (5), $R^7$ independently represents an aliphatic unsaturated bond-free substituted or unsubstituted monovalent hydrocarbon group having 1 to 18 carbon atoms, and g is a number of 1.8 to 2.2, and wherein the organopolysiloxane has a kinetic viscosity of 10 to 100,000 $mm^2/s$ at 25°C; one kind thereof may be used alone, or two or more kinds thereof may be used in combination.

The above $R^7$ independently represents a substituted or unsubstituted monovalent hydrocarbon group having 1 to 18 carbon atoms. Examples of $R^7$ include an alkyl group such as a methyl group, an ethyl group, a propyl group, a hexyl group, an octyl group, a decyl group, a dodecyl group, a tetradecyl group, a hexadecyl group, and an octadecyl group; a cyclohexyl group such as a cyclopentyl group and a cyclohexyl group; an alkenyl group such as a vinyl group and an allyl group; an aryl group such as a phenyl group and a tolyl group; an aralkyl group such as 2-phenylethyl group and 2-methyl-2-phenylethyl group; and a halogenated hydrocarbon group such as 3,3,3-trifluoropropyl group, 2-(perfluorobutyl) ethyl group, 2-(perfluorooctyl)ethyl group, and p-chlorophenyl group.

The composition of the present invention may further contain, for example, a heat resistance improver such as iron oxide and cerium oxide; a viscosity modifier such as silica; or a colorant.

<Viscosity of composition>

As described later, the composition of the present invention is coated to the surface of a heat-generating

electronic component, and a heat dissipation member is then press-bonded thereto, followed by performing a heating treatment to cure the composition so as to form a thermally conductive layer. At that time, for the sake of favorable workability, the composition of the present invention needs to be in the form of a grease.

For example, the composition of the present invention is stored in a syringe, and the composition from this syringe is coated to the surface of a heat-generating electronic component such as a CPU to form a coating layer to which a heat dissipation member is then press-bonded. Thus, the viscosity of the composition of the present invention is normally 10 to 1,000 Pa·s, particularly preferably 30 to 400 Pa·s. An excessively low viscosity will lead to dripping at the time of coating, which may cause problems in workability. Meanwhile, an excessively high viscosity will make it difficult for the composition to be pushed out from the syringe, which may lead to poor work efficiency when performing coating. Here, this viscosity is a value measured by the spiral viscometer PC-1TL (by Malcom Co., Ltd.) at 25°C.

[Preparation of composition]

The curable organopolysiloxane composition of the present invention can be produced by a production method having:

(i) a step of kneading the components (A), (C), and (D), and optionally the component (G-1), as well as components (G-2) and (G-3), if the components (G-2) and (G-3) are to be contained, at a temperature that is within a range of 20 to 120°C and is not lower than the melting point of the component (C) to obtain a uniform mixture;
(ii) a step of stopping the kneading of the mixture (i) and cooling the mixture (i) to a temperature lower than the melting point of the component (C) to obtain a mixture (ii); and
(iii) a step of adding to the mixture (ii) the components (B) and (E) as well as the component (F) and other components, if the component (F) and such other components are to be contained, and then performing kneading at a temperature lower than the melting point of the component (C) to obtain a uniform mixture (iii).

However, the production method shall not be limited to the one as noted above.

In this production method, there is used a stirring and kneading machine such as a conditioning mixer or planetary mixer equipped with a heating unit and even a cooling unit if necessary.

In the step (i), a liquid substance of the gallium and/or alloy thereof as the component (C), and the thermally conductive filler as the component (D) are to be uniformly dispersed into a mixed liquid prepared by combining the component (A), the component (G-1), and at least one of the components (G-2) and (G-3).

It is preferred that a temperature-lowering operation or cooling operation be carried out swiftly in the step (ii). In the step (ii), as for the component (C) which is in the state of liquid or solid fine particles uniformly dispersed in a matrix composed of the mixed liquid prepared by combining the component (A), the component (G-1), and at least one of the components (G-2) and (G-3), the average particle diameter and dispersed state thereof are retained.

It is preferred that the step (iii) also be finished in a short period of time as much as possible. At a time when the step (iii) is finished, there occurs no substantive change in the dispersed state of the fine particles of the component (C). Next, after finishing the step (iii), the composition produced will be received in a container, and preferably be quickly stored in, for example, a freezer or refrigerator of a temperature of about -30 to -10°C, preferably -25 to -15°C. Further, even for transportation or the like, it is preferable to use, for example, a vehicle having refrigeration equipment. That is, the composition of the present invention is stored or transported under a low temperature in this way, which therefore allows it to hold its composition or dispersed state in a stable manner even when, for example, it is stored for a long period of time.

[Application to semiconductor device]

When the composition of the present invention is to be cured, the composition can be cured by being held at a temperature of 80 to 180°C for about 30 to 240 minutes.

The cured product of the composition of the present invention may be interposed between a heat-generating electronic component and a heat dissipation member for use as a thermally conductive cured product for forming a thermally conductive layer.

In such case, the composition of the present invention may be used to obtain a semiconductor device superior in heat dissipation property, i.e., a semiconductor device having a heat-generating electronic component, a heat dissipation member, and a thermally conductive layer composed of the cured product of the composition of the present invention, where the heat-generating electronic component and the heat dissipation member are bonded via the thermally conductive layer.

It is preferred that the cured product of the composition of the present invention exhibits a storage elastic modulus at 25°C of 3,000 to 300,000 Pa, more preferably of 5,000 to 200,000 Pa, and even more preferably of 10,000 to 150,000 Pa. A storage elastic modulus of less than 3,000 Pa is more likely to form a void, and the product may be flown out from the

predetermined position, thus resulting in poor reliability. Meanwhile, a storage elastic modulus larger than 300,000 Pa may fail to conform with the warpage produced upon operation of heat-generating components such as CPU and prevents desired heat dissipating properties from being obtained.

The semiconductor device can be produced by a production method having:

(a) a step of applying the composition of the present invention to a surface of a heat-generating electronic component to form thereon a coating layer composed of the composition;
(b) a step of press-bonding and fixing a heat dissipation member to the coating layer; and
(c) a step of heating a structural body obtained after the step (b) at 80 to 180°C to cure and turn the coating layer into a thermally conductive layer.

The semiconductor device and the production method thereof are described with reference to FIG. 1. Here, the device shown in FIG.1 is merely one example of an application of the composition of the present invention to a semiconductor device; the semiconductor device of the present invention shall not be limited to the device shown in FIG. 1.

In the beginning, the composition of the present invention that is in a frozen and stored state is left under room temperature to be naturally defrosted and turned into a grease-like substance. Next, the liquid composition of the present invention is put into a coating tool such as a syringe.

The composition of the present invention is then applied (dispensed) from the syringe or the like to the surface of a heat-generating electronic component, e.g, a CPU 2 as a heat-generating electronic component mounted on a board 3 shown in FIG. 1, thereby forming a curable composition layer (coating layer) 1. In addition, an adhesive agent 5 is applied at the same time for fixing a heat dissipation member 4, whereby the heat dissipation member 4 is to be fixed thereon by being press-bonded to the CPU2 via the coating layer 1.

There, the thickness of the coating layer 1 sandwiched by the CPU 2 and the heat dissipation member 4 is normally adjusted to 5 to 100 μm, particularly preferably 10 to 70 μm. An unduly small thickness will make peeling more likely to occur, which will result in poor reliability; meanwhile, an excessively large thickness will lead to a large thermal resistance such that a satisfactory heat dissipation effect cannot be achieved.

Next, the device as configured in the above manner is placed in a heating device to cure the coating layer 1 composed of the composition of the present invention and thus turn it into a thermally conductive layer 1. The temperature required for this curing process is 80 to 180°C, particularly preferably 100 to 150°C. A temperature of lower than 80°C may lead to insufficient curing; meanwhile, a high temperature greater than 180°C may cause electronic components and base materials to deteriorate.

During the process of raising the temperature to the temperature required for curing, the liquid fine particles of the gallium and/or alloy thereof as the component (C) in the composition of the present invention will also be combined with the component (D) to form a kind of continuous path.

Moreover, the liquid particles of the component (C) will also be fused onto the surfaces of the CPU 2 and the heat dissipation member 4 that are in contact with the composition. Thus, the CPU 2 and the heat dissipation member 4 are substantially rich in an integrally continuous thermal conductivity via the kind of continuous path formed by combining the liquid particles of the component (C) and the thermally conductive filler as the component (D). Further, the path-like structure is immobilized and retained in the three-dimensional crosslinked network body of the cured product formed by the addition reaction between the components (A) and (B).

Further, when operating or using the semiconductor device obtained in the above manner, a heat-generating electronic component such as a CPU normally has a high surface temperature of about 60 to 120°C. With regard to this heat generation, the thermally conductive layer composed of the cured product of the composition of the present invention exhibits a high thermal conductivity as explained above, and brings about significantly superior functionality and efficacy of exhibiting a more excellent heat dissipation property as compared to the conventional thermally conductive sheets and thermally conductive greases. In addition, even when the semiconductor device is continuously operated or used for a long period of time, the gallium and/or alloy thereof as the component (C) forming the path contained in the thermally conductive layer will not leak form the thermally conductive layer as the component (C) is immobilized and retained in the three-dimensional crosslinked network body of the cured product.

Further, since this thermally conductive layer has a tackiness, it has stable flexibility even when the heat dissipation member has been misaligned or the device has been used for a long period of time, thereby preventing the thermally conductive layer from being peeled off from the heat-generating electronic component or the heat dissipation member.

Here, similar effects can be achieved by previously producing a sheet-like cured product with a desired thickness from the composition of the present invention, and then interposing such cured product between a heat-generating electronic component and a heat dissipation member as are the cases with the conventional thermally conductive sheets. Other than that, the sheet or the like of the cured product of the composition of the present invention may also be

appropriately used as a part(s) of any other devices or the like requiring thermal conductivity and heat resistance.

## Examples

The present invention is described in greater detail hereunder with reference to working examples; however, the invention shall not be limited to these working examples.

The components (A) to (G) used in the following working and comparative examples are shown below. Here, viscosity is a value measured at 25°C by a spiral viscometer PC-1TL (by Malcom Co., Ltd.), and kinetic viscosity is a value measured at 25°C by an Ostwald viscometer.

Component (A):

Dimethylpolysiloxane with both terminals being blocked by dimethylvinylsilyl groups, and whose viscosities at 25°C are specified as:

(A-1-1) Viscosity: 0.1 Pa·s,
(A-1-2) Viscosity: 1.0 Pa·s,
(A-2-1) Viscosity: 30 Pa·s, and
(A-2-2) Viscosity: 100 Pa·s.

Component (B):

(B-1) Organohydrogenpolysiloxane ($\alpha/\beta$ = 0.35, kinetic viscosity at 25°C of 113 $mm^2/s$) represented by a structural formula defined as:

[Chem. 3]

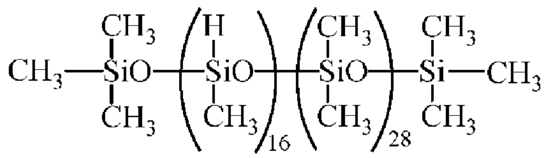

wherein, in the formula, the siloxane units in the parentheses are arranged in arbitrary orders.

(B-2) Organohydrogenpolysiloxane ($\alpha/\beta$ = 0.29, kinetic viscosity at 25°C of 27 $mm^2/s$) represented by a structural formula defined as:

[Chem. 4]

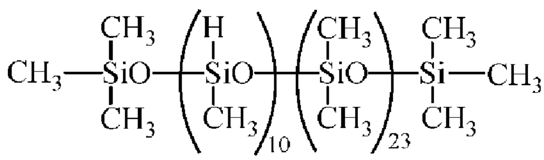

wherein, in the formula, the siloxane units in the parentheses are arranged in arbitrary orders.

Component (C):

(C-1) Metal gallium [melting point = 29.8°C]
(C-2) Ga-In alloy [mass ratio = 75.4:24.6, melting point = 15.7°C]
(C-3) Ga-In-Sn alloy [mass ratio = 68.5:21.5:10, melting point = -19°C]

(C-4) Ga-In-Sn alloy [mass ratio = 62:25:13, melting point = 5.0°C]

Component (D):

(D-1): Alumina powder [average particle diameter: 8.2 μm]
(D-2): Zinc oxide powder [average particle diameter: 1.0 μm]

Component (E):

(E-1): Dimethylpolysiloxane (with both terminals being blocked by dimethylvinylsilyl groups, viscosity: 0.6 Pa·s) solution of platinum-divinyltetramethyldisiloxane complex [platinum atom content: 1% by mass]

Component (F):

(F-1) 1-ethynyl-1-cyclohexanol

Component (G):

(G-1) Dimethylpolysiloxane with one terminal being blocked by a trimethoxysilyl group, that has a kinetic viscosity of 32 mm²/s and is represented by a structural formula defined as:

[Chem. 5]

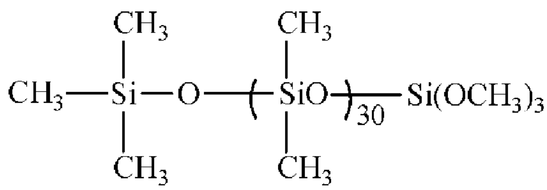

(G-2) Organosilane represented by a structural formula: $C_{10}H_{21}Si(OCH_3)_3$
(G-3) Trifluoropropyltrimethoxysilane

Here, in the process of preparing the composition, the term "component (G)" as used herein refers to a collective expression referring to (G-1), (G-2) and (G-3) used in each example listed in Table 1.

[Working examples 1 to 6; Comparative examples 1 to 5]

<Preparation of composition>

The components were taken at the composition ratios shown in Table 1, and the composition was prepared in the following manner.

The components (A), (C), (D) and (G) were added to the container of a conditioning mixer having an inner capacity of 250 mL (product name: Awatori Rentaro manufactured by THINKY CORPORATION), where the temperature was raised to and maintained at 70°C, and kneading was performed for 5 minutes. Next, kneading was stopped, and the mixture was cooled to 15°C.

Subsequently, the components (B), (E) and (F) were added to the mixture of the components (A), (C), (D) and (G), where the components were kneaded at 25°C until the mixture became uniform to prepare each composition.

<Viscosity measurement>

The absolute viscosity of the composition was measured by the viscometer of the model number PC-1TL manufactured by Malcom Co., Ltd. (10 rpm) at 25°C in each example.

<Particle diameter measurement of component (C)>

Each composition obtained above was sandwiched by two pieces of glass slide, where 30 particles were randomly selected from an image taken by VR-3000 manufactured by KEYENCE CORPORATION, and the particle diameter of each particle was then measured from which an average value thereof was calculated.

<Solidifying temperature measurement of component (C)>

The resultant compositions were each analyzed using a Differential Scanning Calorimeter (DSC) of the model DSC7000X manufactured by Hitachi High-Tech Science Corporation. The solidifying temperature was determined as a temperature of the maximum peak position of the exothermic curve obtained after it was cooled at 3°C/minute from 25°C to -80°C.

<Preparation of cured product>

The resultant compositions were each coated to the entire surface of an aluminum plate having a diameter of 1.26 mm and a thickness of 1 mm (hereafter referred to as "standard aluminum plate"), and another standard aluminum plate was further stacked thereon, followed by applying a pressure of about 175.5 kPa (1.80 kgf/$cm^2$) thereto to obtain a triple-layered structural body. Next, this triple-layered structural body was put into an electric furnace, where the temperature was raised and then maintained at 150°C for an hour to cure the composition. Later, the structural body was left to be cooled to room temperature, thereby obtaining a specimen for thermal resistance measurement.

The thickness of each specimen obtained was measured, where the thickness of each cured composition product was calculated by subtracting therefrom the known thicknesses of the standard aluminum plates. Here, a micrometer (model; M820-25VA by Mitutoyo Corporation) was used to measure the thickness of each specimen. The thicknesses of the respective cured composition products are shown in Table 1.

<Initial thermal resistance measurement>

Using each specimen, the thermal resistance ($mm^2 \cdot K/W$) of each cured composition product was measured by a thermal resistance measurement device (model: LFA447 by NETZSCH Japan K.K.). The initial measurement results are shown in Tables 1 to 3.

<Thermal resistance measurement after thermal shock test>

After measuring the initial thermal resistance, the specimen was placed in a rapid rise/fall type low-temperature incubator (model SP-61NX-A) by Kato Corporation to measure the thermal resistance after repeating 1,000 cycles of the cycle defined as a condition of -55°C for 30 minutes and 125°C for 30 minutes. The measurement results are as shown in Table 1.

<Void test>

Here, 0.2 g of each composition product was sandwiched by two pieces of glass slide each having a size of 5×7 cm, and they were then left at room temperature for 15 min with a 1 kg weight being placed thereon. Later, the weight was removed, and the test specimen was then left in an oven of 150°C for an hour before being taken out therefrom. The cured product sandwiched between the glass slides was observed visually and by a microscope (model VR-3200 by KEYENCE CORPORATION).

[Evaluation]

Cracks were observed visually: ×
One or more circular voids (pores) with a diameter of 1.0 mm or larger were observed via the microscope: ×
No cracks or circular voids (pores) with a diameter of 1.0 mm or larger were observed at all neither visually nor via the microscope: o

<Measurement of storage elastic modulus>

A rheometer (ARES-G2 manufactured by TA Instruments was used) with two pieces of parallel plates having diameters of 2.5 cm (Thickness of the curable organopolysiloxane composition was set as 2 mm) was used.

The measurement was initiated at room temperature, and the temperature was raised at 10°C/minute to 125°C, and then the temperature was further raised at 2°C/minute from 125°C to 150°C from which the temperature was held at 150°C for two hours to fully cure the composition. After that, the composition was cooled to 25°C to measure the storage elastic modulus of the cured product of the composition (Frequency: 1.0 rad/sec; Strain (displacement) was set at 1%).

<Thermal conductivity measurement>

The thermal conductivity of each specimen was measured at 25°C by TPS-2500S manufactured by KYOTO ELECTRONICS MANUFACTURING CO., LTD.

<Particle diameter measurement of component (D)>

The particle diameter of the thermally conductive filler is a cumulative average size on a volumetric basis that is measured by Microtrac MT3300EX which is a particle diameter analyzer manufactured by Nikkiso Co., Ltd.

<Application to semiconductor device>

Here, 0.2 g of each composition obtained in the working examples 1 to 6 was coated to the surface of a 2 cm × 2 cm CPU to form a coating layer. A heat dissipation member was then stacked on this coating layer before curing the coating layer, thereby obtaining a semiconductor device with the CPU and heat dissipation member being bonded together via a **thermally conductive layer having a thickness of 10 to 70** μm. Each device was installed into a host computer, a personal computer or the like, and then was operated. As a result, although the heat temperature of the CPU was about 100°C, each device was able to exhibit stable thermal conductance and heat dissipation for a long period of time, thereby making it possible to prevent, for example, performance deterioration and breakage of the CPU which are caused by cumulative overheating. Thus, it was confirmed that a semiconductor device was able to have its reliability improved by employing the cured product of the composition of the present invention.

[Table 1]

| | | | Working Example | | | | | | Comparative Example |
|---|---|---|---|---|---|---|---|---|---|
| | | | 1 | 2 | 3 | 4 | 5 | 6 | 1 |
| Composition (parts by mass) | (A) | A-1-1 | 40 | 60 | 70 | 70 | | 70 | 40 |
| | | A-1-2 | | | | | 50 | | |
| | | A-2-1 | 60 | 40 | 30 | | 50 | | 60 |
| | | A-2-2 | | | | 30 | | 30 | |
| | (B) | B-1 | 5 | 6 | | 4.7 | | 7 | 5 |
| | | B-2 | | | 7.5 | | 4 | | |
| | SiH/Vi * | | 1.5 | 1.3 | 1 | 0.9 | 2 | 1.3 | 1.5 |
| | (C) | C-1 | 3500 | | | | | | 3500 |
| | | C-2 | | 7000 | | | 7000 | | |
| | | C-3 | | | 11000 | | | 12000 | |
| | | C-4 | | | | 5000 | | | |
| | (D) | D-1 | 200 | 100 | | 50 | 50 | 70 | |
| | | D-2 | 50 | | 50 | | 50 | | |
| | (E) | E-1 | 0.3 | 0.3 | 0.5 | 0.3 | 0.3 | 0.5 | 0.3 |
| | (F) | F-1 | 0.3 | 0.3 | 0.3 | 0.3 | 0.3 | 0.3 | 0.3 |
| | (G) | G-1 | 50 | 80 | 200 | 80 | 80 | 300 | 50 |
| | | G-2 | | 20 | 50 | | 20 | 10 | |
| | | G-3 | | | | 10 | | | |
| Viscosity (Pa·s) | | | 70 | 110 | 120 | 80 | 170 | 210 | 20 |
| Particle diameterof Component (C) (μm) | | | 50 | 30 | 60 | 80 | 35 | 20 | 250 |
| Solidifying temperature (°C) of Component (C) | | | -62 | -70 | -64 | -75 | -72 | -75 | -35 |
| Thermal conductivity (W/mK) | | | 5.2 | 6.8 | 6.5 | 5.9 | 6.7 | 6.4 | 4.9 |
| Void test | | | ○ | ○ | ○ | ○ | ○ | ○ | ○ |
| Thickness of specimen (μm) | | | 22 | 17 | 10 | 20 | 21 | 20 | 8 |
| Storage elastic modulus at 25°C (Pa) | | | 123,000 | 95,000 | 78,000 | 35,000 | 150,000 | 110,000 | 110,000 |
| Initial thermal resistance ($mm^2 \cdot K/W$) | | | 1.5 | 1.1 | 1 | 1.4 | 1.2 | 1.1 | 0.9 |
| Thermal resistance measured after thermal shock test ($mm^2 \cdot K/W$) | | | 1.6 | 1.1 | 1.1 | 1.4 | 1.2 | 1.2 | 22 |

*The ratio of the number of silicon atom-bonded hydrogen atoms in the component (B) relative to one silicon atom-bonded alkenyl group in the component (A) is expressed as SiH/Vi.

The results indicate that the component (C) having a solidifying point lower than the desired temperature fails to withstand the thermal shock test and leads to a deteriorated thermal resistance.

Reference Signs List

1 Curable composition layer (coating layer) (thermally conductive layer)
2 CPU (Central processing unit)
3 Board
4 Heat dissipation member
5 Adhesive agent

## Claims

**1.** A curable organopolysiloxane composition comprising the components (A) to (E) of:

(A) an organopolysiloxane having at least two silicon atom-bonded alkenyl groups per each molecule, said organopolysiloxane being liquid at 25°C;
(B) an organohydrogenpolysiloxane having a silicon atom-bonded hydrogen atom;
(C) at least one selected from the group consisting of gallium and a gallium alloy that have a melting point of -20 to 70°C;
(D) a thermally conductive filler having an average particle diameter of 0.1 to 30 μm; and
(E) a platinum group metal catalyst,

wherein the gallium and/or the gallium alloy (C) is in the form of particles dispersed in the organopolysiloxane and exhibits a solidifying point of -40°C or lower.

**2.** The curable organopolysiloxane composition according to claim 1, comprising the components (A) to (G1) of:

(A) 100 parts by mass of organopolysiloxane consisting of:

(A-1) an organopolysiloxane having at least two silicon atom-bonded alkenyl groups per each molecule and having a viscosity of 0.01 to 10 Pa·s at 25°C; and
(A-2) an organopolysiloxane having at least two silicon atom-bonded alkenyl groups per each molecule and having a viscosity of 11 to 1,000 Pa·s at 25°C,

wherein a ratio by mass of the (A-1) relative to the total amount by mass of the (A-1) and (A-2) is 10 to 90% by mass;
(B) an organohydrogenpolysiloxane having at least two silicon atom-bonded hydrogen atoms per each molecule, the component (B) being in an amount where the number of the silicon atom-bonded hydrogen atoms in the component is 0.1 to 5.0 per one alkenyl group in the component (A);
(C) 300 to 20,000 parts by mass of at least one selected from the group consisting of gallium and a gallium alloy that have a melting point of -20 to 70°C;
(D) 10 to 1,000 parts by mass of a thermally conductive filler having an average particle diameter of 0.1 to 30 μm;
(E) 0.1 to 500 ppm of a platinum group metal catalyst in terms of platinum group metal mass with respect to the mass of the component (A); and
(G-1) 10 to 500 parts by mass of an organopolysiloxane represented by a general formula (1) define as:

[Chemical formula 1]

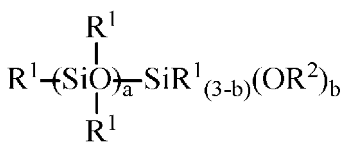

(1)

wherein, in the formula (1), $R^1$s represent identical or different alkyl groups, $R^2$ represents an alkyl group, an alkenyl group, or an acyl group, a is an integer of 5 to 100, b is an integer of 1 to 3.

**3.** The curable organopolysiloxane composition according to claim 2, further comprising
(G-2) 0.1 to 100 parts by mass of an alkoxysilane compound per 100 parts by mass of the component (A), said alkoxysilane compound being represented by a general formula (2) defined as

$$R^3_cR^4_dSi(OR^5)_{4-c-d} \qquad (2)$$

wherein, in the formula (2), $R^3$ independently represents an alkyl group having 6 to 16 carbon atoms, $R^4$ independently represents a substituted or unsubstituted monovalent hydrocarbon group having 1 to 8 carbon atoms, $R^5$ independently represents an alkyl group having 1 to 6 carbon atoms, c is an integer of 1 to 3, d is an integer of 0 to 2, and a sum of c + d is an integer of 1 to 3.

**4.** The curable organopolysiloxane composition according to claim 2 or 3, further comprising (G-3) 0.1 to 100 parts by mass of trifluoropropyltrimethoxysilane per 100 parts by mass of the component (A).

**5.** The curable organopolysiloxane composition according to claim 1, wherein the component (B) is an organohydrogenpolysiloxane that has 5 or more silicon atom-bonded hydrogen atoms at non-terminal moieties of the molecular chain per molecule, and satisfies a formula (3) defined as:

$$0.1 < \alpha/\beta \qquad (3),$$

wherein, in the formula (3), $\alpha$ represents the number of the hydrogen atoms bonded to the silicon atoms at the non-terminal moieties of the molecular chain, and $\beta$ represents the number of all the silicon atoms in the component (B).

**6.** The curable organopolysiloxane composition according to claim 1, wherein the component (C) is dispersed in the composition in the form of particles each having a diameter of 1 to 200 μm.

**7.** A thermally conductive silicone grease composition comprising the curable organopolysiloxane composition according to claim 1.

**8.** A cured product of the curable organopolysiloxane composition according to claim 1.

**9.** The cured product of the curable organopolysiloxane composition according to claim 8, wherein the product exhibits a storage elastic modulus of 3,000 to 300,000 Pa at 25°C.

**10.** A use of the cured product according to claim 8 as a thermally conductive layer that is sandwiched and arranged between a heat-generating electronic component and a heat dissipation member.

**11.** A semiconductor device comprising:

a heat-generating electronic component;
a heat dissipation member; and
a thermally conductive layer composed of the cured product according to claim 8,
wherein the heat-generating electronic component and the heat dissipation member are bonded via the thermally conductive layer.

**12.** A method of producing the semiconductor device according to claim 11, comprising the steps of:

(a) applying the curable organopolysiloxane composition according to claim 1 to a surface of a heat-generating electronic component to form thereon a coating layer composed of the composition;
(b) press-bonding and fixing a heat dissipation member to the coating layer; and
(c) heating a structural body obtained after the step (b) at 80 to 180°C to cure and turn the coating layer into a thermally conductive layer.

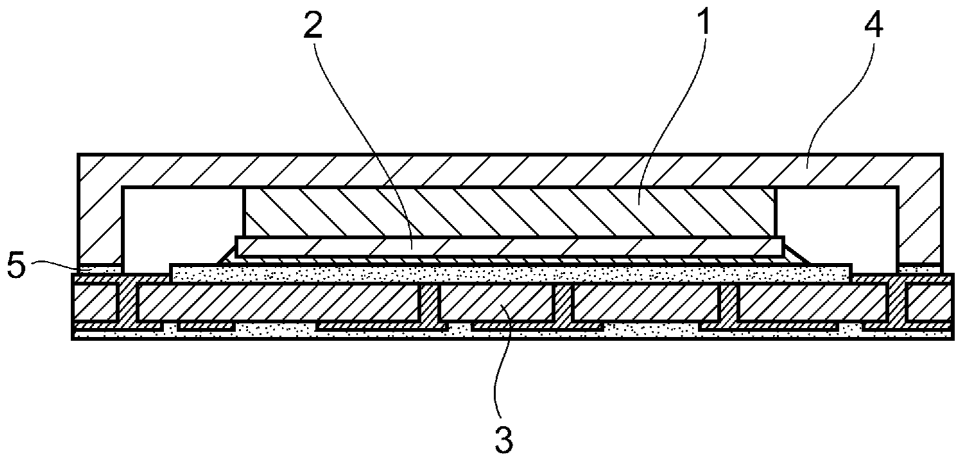


FIG.1

## INTERNATIONAL SEARCH REPORT

International application No.
**PCT/JP2023/034513**

**A. CLASSIFICATION OF SUBJECT MATTER**

***C08L 83/07***(2006.01)i; ***C08K 3/013***(2018.01)i; ***C08K 3/105***(2018.01)i; ***C08L 83/05***(2006.01)i; ***C09K 5/14***(2006.01)i; ***H01L 23/36***(2006.01)i; ***H01L 23/373***(2006.01)i
FI: C08L83/07; C08K3/013; C08K3/105; C08L83/05; C09K5/14 101E; H01L23/36 D; H01L23/36 M

According to International Patent Classification (IPC) or to both national classification and IPC

**B. FIELDS SEARCHED**

Minimum documentation searched (classification system followed by classification symbols)

C08L83/07; C08K3/013; C08K3/105; C08L83/05; C09K5/14; H01L23/36; H01L23/373

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2005-112961 A (SHIN-ETSU CHEMICAL CO., LTD.) 28 April 2005 (2005-04-28) claims 1-8, paragraphs [0006], [0008], [0027], [0039]-[0042], [0050], examples 1, 2 | 1, 5-12<br>2-4 |
| Y | JP 2011-144234 A (DENKI KAGAKU KOGYO KK) 28 July 2011 (2011-07-28) claims 1-3, paragraphs [0005], [0014], [0015], example 1 | 2-4 |
| A | JP 2010-018662 A (SHIN-ETSU CHEMICAL CO., LTD.) 28 January 2010 (2010-01-28) paragraph [0042] | 1-12 |
| A | JP 2013-010862 A (SHIN-ETSU CHEMICAL CO., LTD.) 17 January 2013 (2013-01-17) entire text | 1-12 |
| A | JP 2015-078296 A (SHIN-ETSU CHEMICAL CO., LTD.) 23 April 2015 (2015-04-23) entire text | 1-12 |
| A | WO 2020/129555 A1 (SHIN-ETSU CHEMICAL CO., LTD.) 25 June 2020 (2020-06-25) entire text | 1-12 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 October 2023** | **24 October 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/034513**

**C. DOCUMENTS CONSIDERED TO BE RELEVANT**

| Category* | Citation of document, with indication, where appropriate, of the relevant passages | Relevant to claim No. |
|---|---|---|
| A | WO 2020/203299 A1 (DOW TORAY CO., LTD.) 08 October 2020 (2020-10-08) entire text | 1-12 |

Form PCT/ISA/210 (second sheet) (January 2015)

**INTERNATIONAL SEARCH REPORT**
**Information on patent family members**

International application No.
**PCT/JP2023/034513**

| Patent document cited in search report | Publication date (day/month/year) | Patent family member(s) | Publication date (day/month/year) |
|---|---|---|---|
| JP 2005-112961 A | 28 April 2005 | US 2005/0084691 A1<br>claims 1-13, paragraphs [0013], [0016], [0054], [0069]-[0075], [0094], examples 1, 2 | |
| JP 2011-144234 A | 28 July 2011 | (Family: none) | |
| JP 2010-018662 A | 28 January 2010 | (Family: none) | |
| JP 2013-010862 A | 17 January 2013 | (Family: none) | |
| JP 2015-078296 A | 23 April 2015 | (Family: none) | |
| WO 2020/129555 A1 | 25 June 2020 | US 2022/0044983 A1<br>entire text<br>EP 3901998 A1<br>CN 113228262 A<br>KR 10-2021-0105942 A<br>TW 202033621 A | |
| WO 2020/203299 A1 | 08 October 2020 | US 2022/0169799 A1<br>entire text<br>EP 3951862 A1<br>CN 113519051 A<br>KR 10-2021-0148204 A<br>TW 202100663 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP HEI7207160 A
- JP H0853664 A
- JP 2002121292 A
- JP 4551074 B
- JP 4913874 B
- JP 5640945 B
- JP H07207160 A